# EUROPÄISCHE PATENTANMELDUNG

(11) **EP 4 633 302 A1**
(43) Veröffentlichungstag der Anmeldung: **15.10.2025**
(21) Anmeldenummer: 25168103.7
(22) Anmeldetag: 02.04.2025
(51) Int. Cl.: H05K 7/14

(54) **VERBINDUNGSVORRICHTUNG FÜR EINE AUTOMATISIERUNGSPLATTFORM SOWIE AUTOMATISIERUNGSPLATTFORM**

(30) Priorität: 12.04.2024 DE 102024110300
(71) Anmelder: Murrelektronik GmbH, 71570 Oppenweiler (DE)
(72) Erfinder: Prein, Olaf, 32676 Lügde-Rischenau (DE); Feisst, Heiko, 73278 Schlierbach (DE); Hoffmann, Luca, 71522 Backnang (DE); Matheis, Nils, 71549 Auenwald (DE)
(74) Vertreter: Bösherz Goebel Patentanwälte

(57) **Zusammenfassung**

Die Erfindung betrifft eine Verbindungsvorrichtung (10) für eine Automatisierungsplattform, umfassend ein erstes Kontaktierungsaufnahmeelement (12), das in einer ersten Ebene (E1) angeordnet ist und das ausgebildet ist, eine erste Kontaktierung mit einem zu dem ersten Kontaktierungsaufnahmeelement (12) korrespondierenden ersten Kontaktierungselement (22) eines Funktionsmoduls (20) bereitzustellen, und ein zweites Kontaktierungsaufnahmeelement (14), das in einer zweiten Ebene (E2), die sich von der ersten Ebene unterscheidet und vorzugsweise zu der ersten Ebene (E1) gewinkelt ist, angeordnet ist und das ausgebildet ist, eine zweite Kontaktierung mit einem zu dem zweiten Kontaktierungsaufnahmeelement (14) korrespondierenden zweiten Kontaktierungselement des Funktionsmoduls (20) bereitzustellen wobei das erste Kontaktierungsaufnahmeelement (12) ausgebildet ist, zumindest einen von einem Hauptenergiefluss, einem Hilfsenergiefluss und einem Datenfluss über das erste Kontaktierungselement (22) an das Funktionsmodul (20) bereitzustellen und wobei das zweite Kontaktierungsaufnahmeelement (14) ausgebildet ist, zumindest einen weiteren von einem Hauptenergiefluss, einem Hilfsenergiefluss und einem Datenfluss über das zweite Kontaktierungselement an das Funktionsmodul (20) bereitzustellen.

## Beschreibung

Die vorliegende Erfindung betrifft eine Verbindungsvorrichtung für eine Automatisierungsplattform sowie eine Automatisierungsplattform und eine Anlage mit einer solchen Verbindungsvorrichtung.

Aus dem Stand der Technik ist es bekannt, dass modulare Automatisierungslösungen dafür genutzt werden, um in einer industriellen Anlage elektrische Geräte über Energieleitungen mit Energie zu versorgen und über Steuerungsleitungen, wie z. B. Feldbusleitungen, anzusteuern. Die Modularität wird dabei oft dadurch erreicht, dass einzelne, voneinander unabhängige Funktionsmodule verwendet werden, die individuell konfiguriert und kombiniert werden können. Dies hat den Vorteil, dass die Automatisierungslösungen flexibel an die jeweiligen Anforderungen der industriellen Anlage angepasst werden können und somit eine hohe Effizienz und Wirtschaftlichkeit gewährleisten.

Die Druckschrift US 2013/0342152 A1 offenbart eine Mehrwellenmotorantriebsvorrichtung, bei welcher mindestens ein Verstärkermodul, ein Steuersubstrat und ein Leistungssubstrat vorgesehen sind.

Die Druckschriften WO 2012/000808 A1, WO 2023/088883 A1 und EP 2 728 673 B1 offenbaren weitere gattungsgemäße Lösungen.

Es ist bei herkömmlichen Lösungen häufig ein Problem, dass eine Montage von Funktionsmodulen einer Automatisierungsplattform aufwändig und fehleranfällig sein kann. Es ist daher eine Aufgabe der vorliegenden Erfindung, die voranstehend beschriebenen Nachteile zumindest teilweise zu beheben. Es ist insbesondere eine Aufgabe der vorliegenden Erfindung, die Verbindung von Funktionsmodulen mit einer gemeinsamen Verbindungsvorrichtung zu verbessern.

### Offenbarung der Erfindung

Gegenstand der Erfindung ist eine Verbindungsvorrichtung mit den Merkmalen des Anspruchs 1 sowie eine Automatisierungsplattform mit den Merkmalen des Anspruchs 9 und eine Anlage mit den Merkmalen des Anspruch 15. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Verbindungsvorrichtung beschrieben sind, selbstverständlich auch im Zusammenhang mit der erfindungsgemäßen Automatisierungsplattform und der Anlage und jeweils umgekehrt, so dass bezüglich der Offenbarung zu den einzelnen Erfindungsaspekten stets wechselseitig Bezug genommen wird bzw. werden kann.

Gegenstand der Erfindung ist insbesondere eine Verbindungsvorrichtung für eine Automatisierungsplattform.

Die erfindungsgemäße Verbindungsvorrichtung kann umfassen:
- ein erstes Kontaktierungsaufnahmeelement, das in einer ersten Ebene angeordnet ist und das ausgebildet ist, eine erste Kontaktierung mit einem zu dem ersten Kontaktierungsaufnahmeelement korrespondierenden ersten Kontaktierungselement eines Funktionsmoduls bereitzustellen, und/oder
- ein zweites Kontaktierungsaufnahmeelement, das in einer zweiten Ebene, die sich von der ersten Ebene unterscheidet und vorzugsweise zu der ersten Ebene gewinkelt ist, angeordnet ist und das ausgebildet ist, eine zweite Kontaktierung mit einem zu dem zweiten Kontaktierungsaufnahmeelement korrespondierenden zweiten Kontaktierungselement des Funktionsmoduls bereitzustellen.

Ferner kann das erste Kontaktierungsaufnahmeelement ausgebildet sein, zumindest einen von einem Hauptenergiefluss, einem Hilfsenergiefluss und einem Datenfluss über das erste Kontaktierungselement an das Funktionsmodul bereitzustellen.

Ferner kann das zweite Kontaktierungsaufnahmeelement ausgebildet sein, zumindest einen weiteren von einem Hauptenergiefluss, einem Hilfsenergiefluss und einem Datenfluss über das zweite Kontaktierungselement an das Funktionsmodul bereitzustellen.

Es kann das erste Kontaktierungsaufnahmeelement optional ausgebildet sein, zumindest einen von einem Hauptenergiefluss, einem Hilfsenergiefluss und einem Datenfluss, d. h. den Hauptenergiefluss und/oder den Hilfsenergiefluss und/oder den Datenfluss, über das erste Kontaktierungselement an das Funktionsmodul bereitzustellen. Weiter kann das zweite Kontaktierungsaufnahmeelement optional ausgebildet sein, zumindest einen weiteren von einem Hauptenergiefluss, einem Hilfsenergiefluss und einem Datenfluss, d. h. insbesondere den Hauptenergiefluss und/oder den Hilfsenergiefluss und/oder den Datenfluss, jedoch vorzugsweise nicht den Fluss, der bereits von dem ersten Kontaktierungsaufnahmeelement bereitgestellt wird, über das zweite Kontaktierungselement an das Funktionsmodul bereitzustellen.

Unter einem Fluss kann dabei vorzugsweise ein elektrischer Fluss, also bevorzugt ein elektrischer Stromfluss zur Energieversorgung und/oder Datenaustausch, verstanden werden. Der Datenfluss kann im Gegensatz zum Haupt- und/oder Hilfsenergiefluss nicht primär zur Energieversorgung, sondern zum Datenaustausch vorgesehen sein.

Vorteilhafterweise kann die Verbindungsvorrichtung und/oder die Automatisierungsplattform und/oder eine jeweilige erfindungsgemäße Automatisierungsplattform zur Automatisierung bei einer industriellen Anlage wie einer Automatisierungsanlage und/oder der erfindungsgemäßen industriellen Anlage dienen. Entsprechend kann die Energieversorgung über den Haupt- und/oder Hilfsenergiefluss zur Energieversorgung wenigstens einer Komponente bei dieser Anlage dienen und/oder zur Bereitstellung von zumindest einem Prozess und vorzugsweise Automatisierungsprozess vorgesehen sein. Ein Datenaustausch über den Datenfluss kann bevorzugt ebenfalls zur Automatisierung dienen.

Als eine Automatisierungsplattform, für die die erfindungsgemäße Verbindungsvorrichtung eingerichtet und ausgebildet ist, kann eine Hardware, ggf. mit einer zugehörigen Software, verstanden werden, um in einer elektrischen Anlage bestimmte Prozesse zu automatisieren. Bspw. werden hierbei Motoren, vorzugsweise Servomotoren, angesteuert, und mit diesen ein Roboterarm bewegt oder ein Förderband gesteuert. Die Verbindungsvorrichtung kann dabei zumindest Teil der Automatisierungsplattform sein, um eines oder mehrere Funktionsmodule daran anzuschließen und/oder miteinander zu verbinden, und auf diese Weise modular verschiedene Funktionen für die Automatisierung, wie die Ansteuerung der Motoren, bereitzustellen. Dies kann den Vorteil haben, dass die Verbindungsvorrichtung mit den Funktionsmodulen in der Lage versetzt wird, eine Vielzahl von Geräten und Komponenten in einer elektrischen Anlage zu verbinden und/oder zu steuern und/oder auszuwerten, um eine reibungslose und effiziente Automatisierung zu gewährleisten.

Die Modularität kann dadurch erreicht werden, dass die Funktionsmodule als einzelne, insbesondere voneinander unabhängige Module ausgebildet sind, jeweils mit einem eigenen Modulgehäuse und einer Elektronik, die es erlaubt, die Module individuell zu konfigurieren und mit weiteren Funktionsmodulen funktional zu kombinieren. Auch können die Funktionsmodule Daten- und/oder Energieversorgungs-Schnittstellen zueinander und/oder zu Geräten und/oder Komponenten der elektrischen Anlage aufweisen. Es ist bspw. möglich, dass wenigstens eines der an der Verbindungsvorrichtung angeschlossenen Funktionsmodule in der Lage ist, eine kabelgebundene und/oder drahtlose Verbindung zu einem zu steuernden Gerät und/oder einer Komponente herzustellen. Auch kann wenigstens eines der an der Verbindungsvorrichtung angeschlossenen Funktionsmodule dazu ausgeführt sein, eine Energieversorgung für ein zu steuerndes Gerät und/oder einer Komponente und/oder der weiteren angeschlossenen Funktionsmodule bereitzustellen.

Bei der erfindungsgemäßen Verbindungsvorrichtung kann zunächst ein erstes Kontaktierungsaufnahmeelement vorgesehen sein, welches in einer ersten Ebene der Verbindungsvorrichtung angeordnet ist. Dabei kann das erste Kontaktierungsaufnahmeelement ausgebildet sein, eine erste Kontaktierung mit einem zu dem ersten Kontaktierungsaufnahmeelement korrespondierenden ersten Kontaktierungselement eines solchen Funktionsmoduls bereitzustellen. Ebenso kann ein zweites Kontaktierungsaufnahmeelement vorgesehen sein, dass in einer zweiten Ebene der Verbindungsvorrichtung, die sich von der ersten Ebene unterscheidet und vorzugsweise zu der ersten Ebene gewinkelt ist, angeordnet ist. Das zweite Kontaktierungsaufnahmeelement kann dabei ausgebildet sein, eine zweite Kontaktierung mit einem zu dem zweiten Kontaktierungsaufnahmeelement korrespondierenden zweiten Kontaktierungselement desselben Funktionsmoduls bereitzustellen. Zueinander korrespondierend meint vorliegend insbesondere zueinander passend und/oder komplementär zueinander.

Die erfindungsgemäße Verbindungsvorrichtung kann also zwei, insbesondere unterschiedliche, Kontaktierungsaufnahmeelemente in zwei unterschiedlichen und/oder zueinander gewinkelten Ebenen aufweisen, die ausgebildet sind, zwei jeweils dazu korrespondierende Kontaktierungselemente eines und desselben Funktionsmoduls aufzunehmen und mit diesen eine Kontaktierung herzustellen.

Die erfindungsgemäße Verbindungsvorrichtung kann ferner drei, insbesondere unterschiedliche, Kontaktierungsaufnahmeelemente in zwei oder drei unterschiedlichen und/oder zueinander gewinkelten Ebenen aufweisen, die ausgebildet sind, drei jeweils dazu korrespondierende und insbesondere sich voneinander unterscheidende Kontaktierungselemente eines und desselben Funktionsmoduls aufzunehmen und mit diesen eine Kontaktierung herzustellen.

Die Kontaktierungsaufnahmeelemente, insbesondere das erste und/oder zweite und/oder dritte Kontaktierungsaufnahmeelement, können sich bspw. hinsichtlich ihrer geometrischen Ausbildung und/oder Größe und/oder Fläche und/oder hinsichtlich der elektrischen Eigenschaften (wie eine maximale übertragbare Leistung) und/oder hinsichtlich ihrer Kodierung für eine Verbindung und vorzugsweise Steckverbindung voneinander unterscheiden. Unter einer Kodierung ist dabei insbesondere eine eindeutige Zuordnung der Kontaktierungsaufnahmeelemente zu einer bestimmten Verbindung/Steckverbindung zu verstehen. Dies kann durch eine spezifische Form, Farbe oder Kennzeichnung der Kontaktierungsaufnahmeelemente erfolgen. Die Kontaktierungselemente können sich in entsprechender Weise voneinander unterscheiden.

Eine Kontaktierung meint vorliegend insbesondere das Bereitstellen und/oder Herstellen einer elektrischen, insbesondere signal- und/oder leistungstechnischen Verbindung. Korrespondierend meint vorliegend insbesondere, dass die beiden Elemente zueinander passen, insbesondere funktional und/oder räumlich-körperlich, kompatibel miteinander sind, gleich oder komplementär zueinander geformt sind und/oder ausgebildet sind einander zu ergänzen.

Weiter dient der Begriff "Aufnahme" bei dem ersten und zweiten und ggf. dritten Kontaktierungsaufnahmeelement insbesondere zunächst dazu, diese Elemente von dem dazu korrespondierenden ersten und zweiten und ggf. dritten Kontaktierungselement des Funktionsmoduls begrifflich abzugrenzen und umfasst nicht zwangsläufig eine physikalische Aufnahme des ersten und/oder zweiten Kontaktierungselements, sondern das erste und zweite Kontaktierungsaufnahmeelement stellt lediglich über Kontaktierung und/oder Berührung eine Kontaktierung mit dem jeweiligen Kontaktierungselement des Funktionsmoduls her.

Es kann jedoch auch vorgesehen sein, dass das erste und/oder zweite und/oder dritte Kontaktierungsaufnahmeelement eine oder mehrere Aufnahmeeinrichtungen oder - vorrichtungen umfasst, die ausgebildet sind, das erste und/oder zweite und/oder dritte Kontaktierungselement physikalisch aufzunehmen, insbesondere damit einzugreifen, einzurasten und/oder ineinanderzugreifen, wie dies im weiteren Verlauf noch beschrieben werden wird. Insbesondere kann eines oder beide von dem ersten und/oder zweiten Kontaktierungsaufnahmeelement eine Steckeraufnahme aufweisen und eines oder beide von dem ersten und/oder zweiten Kontaktierungselement einen dazu korrespondierenden Stecker oder andersherum. Das voranstehende gilt auch für das dritte Kontaktierungsaufnahmeelement.

Der Winkel zwischen den zwei Ebenen der Verbindungsvorrichtung kann dabei insbesondere größer 15°, größer 30°, größer 45°, größer 60°, größer 75°, größer 80° oder größer 85° sein. Alternativ oder zusätzlich kann der Winkel zwischen den zwei Ebenen der Verbindungsvorrichtung kleiner als 165°, kleiner 150°, kleiner 135°, kleiner 120°, kleiner 105°, kleiner 100° oder kleiner 95° sein. Insbesondere liegt der Winkel zwischen 85° und 95° und beträgt weiter insbesondere ungefähr, im Wesentlichen oder genau 90°. Insbesondere ist die erste Ebene, in der bzw. entlang der das erste Kontaktierungsaufnahmeelement angeordnet ist, in einer Ebene ungefähr, im Wesentlichen oder genau parallel zu einem Erdboden bzw. Fußboden und die zweite Ebene, in der bzw. entlang der das zweite Kontaktierungsaufnahmeelement angeordnet ist, in einer Ebene ungefähr, im Wesentlichen oder genau senkrecht zu einem Erdboden bzw. Fußboden.

Weiter kann es vorgesehen sein, dass das erste Kontaktierungsaufnahmeelement ausgebildet ist, zumindest einen von einem Hauptenergiefluss, einem Hilfsenergiefluss und/oder einem Datenfluss über das erste Kontaktierungselement an das Funktionsmodul bereitzustellen. Alternativ oder zusätzlich kann es vorgesehen sein, dass das zweite Kontaktierungsaufnahmeelement ausgebildet ist, zumindest einen weiteren, insbesondere einen anderen von einem Hauptenergiefluss, einem Hilfsenergiefluss und/oder einem Datenfluss über das zweite Kontaktierungselement an das Funktionsmodul bereitzustellen. Dabei können sich insbesondere der durch das ersten Kontaktierungsaufnahmeelement bereitgestellte Hauptenergiefluss, Hilfsenergiefluss und/oder Datenfluss von dem durch das zweite Kontaktierungsaufnahmeelement bereitgestellten Hauptenergiefluss, Hilfsenergiefluss und/oder Datenfluss unterscheiden, insbesondere in Flussart und/oder Energiestärke, wie dies ebenfalls noch im weiteren Verlauf beschrieben werden wird. Beispielsweise kann das erste Kontaktierungsaufnahmeelement einen Hilfsenergiefluss an das erste Kontaktierungselement bereitstellen und das zweite Kontaktierungsaufnahmeelement einen Hauptenergiefluss an das zweite Kontaktierungselement bereitstellen.

Die erfindungsgemäße Verbindungsvorrichtung kann dabei auf vorteilhafte Weise ein Funktionsmodul in zwei voneinander verschiedenen Ebenen kontaktieren und dabei insbesondere auch sicher befestigen, um einen oder mehrere von einem Hauptenergiefluss, einem Hilfsenergiefluss und/oder einem Datenfluss in den zwei Ebenen an das Funktionsmodul bereitzustellen.

Es kann im Rahmen der Erfindung vorgesehen sein, dass das erste Kontaktierungsaufnahmeelement und/oder das zweite Kontaktierungsaufnahmeelement und/oder das dritte Kontaktierungsaufnahmeelement zur Ausbildung einer Steckverbindung ausgeführt sind und/oder eine Stift-Buchsen-Kontaktierung umfasst. Insbesondere kann ausschließlich eines von dem ersten Kontaktierungsaufnahmeelement und dem zweiten Kontaktierungsaufnahmeelement eine Stift-Buchsen-Kontaktierung aufweisen, weiter ausschließlich das erste Kontaktierungsaufnahmeelement. Eine Stift-Buchsen-Kontaktierung ist dabei eine Kontaktierungsart, bei der ein oder mehrere Stifte und/oder Stäbe, die auch als männliche Kontaktierung bezeichnet werden können, in eine oder mehrere dazu korrespondierende Buchsen und/oder Steckeraufnahmen, die auch als weibliche Kontaktierung bezeichnet werden können, zur Herstellung einer Steckverbindung eingeführt werden und darin eingreifen, beispielsweise durch Haftreibung. Insbesondere weist das Kontaktierungsaufnahmeelement, weiter insbesondere ausschließlich das erste Kontaktierungsaufnahmeelement, eine oder mehrere Buchsen und/oder Aufnahmen zur Aufnahme eines oder mehrerer Stifte und/oder Stäbe auf und das Kontaktierungselement einen oder mehrere Stifte und/oder Stäbe, die in der bzw. den Buchsen und/oder Aufnahmen des Kontaktierungsaufnahmeelements aufgenommen werden. Hierdurch wird eine besonders sichere Kontaktierung ermöglicht.

Alternativ oder zusätzlich kann vorgesehen sein, dass das erste Kontaktierungsaufnahmeelement und/oder das zweite Kontaktierungsaufnahmeelement und/oder das dritte Kontaktierungsaufnahmeelement eine Federkontaktierung umfasst. Eine Federkontaktierung ist dabei eine Kontaktierungsart, bei der zumindest einer von dem Kontaktierungsaufnahmeelement und dem Kontaktierungselement zumindest abschnittsweise als Feder ausgebildet ist. Die Feder kann dabei durch eine Formgebung in eine bestimmte Richtung vorgespannt sein, insbesondere in eine Einführrichtung, wie dies im weiteren Verlauf noch beschrieben werden wird. Zusätzlich oder alternativ kann vorgesehen sein, dass das erste Kontaktierungselement und/oder das zweite Kontaktierungselement und/oder das dritte Kontaktierungselement des Funktionsmoduls eine Federkontaktierung umfasst. In diesem Fall kann das erste Kontaktierungsaufnahmeelement und/oder das zweite Kontaktierungsaufnahmeelement und/oder das dritte Kontaktierungsaufnahmeelement auch als Flächenkontaktierung ausgebildet sein oder alternativ ebenfalls als Federkontaktierung, die jeweils mit einer Federkontaktierung des Funktionsmoduls zusammenwirkt oder andersherum. Hierdurch wird eine besonders flexible Kontaktierung ermöglicht.

Von weiterem Vorteil kann vorgesehen sein, dass die erste Ebene und die zweite Ebene der Verbindungsvorrichtung derart zueinander angeordnet sind, dass sie eine Einführung des Funktionsmoduls in einer Einführrichtung ermöglichen, die im Wesentlichen senkrecht zu einer von der ersten Ebene und der zweiten Ebene ist und wobei die Federkontaktierung derart angeordnet und ausgebildet ist, dass sie in der Einführrichtung bzw. entgegen dazu federt. Wie zuvor ausgeführt können die erste und zweite Ebene insbesondere ungefähr, im Wesentlichen oder genau in einem rechten Winkel zueinander angeordnet sein. Dabei kann es vorgesehen sein, dass das Funktionsmodul in einer Einführrichtung an die Verbindungsvorrichtung geführt wird, die ungefähr, im Wesentlichen oder genau senkrecht zur ersten Ebene verläuft und die ungefähr, im Wesentlichen oder genau parallel zur zweiten Ebene verläuft. Dabei können insbesondere an dem zweiten Kontaktierungsaufnahmeelement und/oder an dem dazu korrespondierenden Kontaktierungselement des Funktionsmoduls eine Federkontaktierung vorgesehen sein, die derart an der Verbindungsvorrichtung und/oder dem Funktionsmodul angeordnet ist, dass sie in bzw. entgegen der Einführrichtung federt. Hierdurch wird eine besonders resiliente und robuste Kontaktierung ermöglicht.

Gemäß einer vorteilhaften Weiterbildung der Erfindung kann vorgesehen sein, dass die Federkontaktierung eine Toleranz in der Einführrichtung bereitstellt. Dabei kann insbesondere die Federkontaktierung derart angeordnet und ausgebildet sein, dass sie eine Bewegung des Funktionsmoduls in bzw. entgegen der Einführrichtung abfedert und eine Kontaktierung aufrechterhält, auch wenn das Funktionsmodul in bzw. entgegen der Einführrichtung bewegt wird, beispielsweise durch äußere Einflüsse. Die Toleranz kann dabei eine Bewegungstoleranz von beispielsweise 1 mm, 2 mm, 3 mm oder 5 mm in und/oder entgegen der Einführrichtung umfassen. So wird ebenfalls eine besonders resiliente und robuste Kontaktierung ermöglicht.

Vorteilhafterweise kann im Rahmen der Erfindung vorgesehen sein, dass die Federkontaktierung als Federklammer ausgebildet ist. Eine Federklammer ist dabei beispielsweise eine aus zwei Federelementen zusammengesetzte bzw. gebildete Klammer, bei der die Federelemente entgegengesetzt zueinander angeordnet sind, sodass ein dazwischen bestehender Leerraum durch die Vorspannung der Federelemente nach Innen verjüngt wird und dieser Leerraum durch eine Einführbewegung, beispielsweise in Einführrichtung, aufgeweitet wird, sodass das erste und/oder zweite und/oder dritte Kontaktierungselement des Funktionsmoduls darin aufgenommen und sicher gehalten werden kann. Insbesondere ist ausschließlich das erste Kontaktierungsaufnahmeelement als Federklammer ausgebildet. Hierdurch wird eine besonders sichere Kontaktierung ermöglicht.

Ferner kann im Rahmen der Erfindung vorgesehen sein, dass die Federklammer angeordnet und ausgebildet ist, von einem Spreizelement des Funktionsmoduls gespreizt zu werden.

Das Funktionsmodul kann dabei ein Spreizelement aufweisen, das sich beispielsweise in Einführrichtung verjüngt bzw. entgegen der Einführrichtung verbreitert. Insbesondere kann das Spreizelement als Keil ausgebildet sein. Das Spreizelement kann dabei insbesondere an dem ersten und/oder zweiten und/oder dritte Kontaktierungselement des Funktionsmoduls angeordnet sein, weiter insbesondere ausschließlich an dem ersten Kontaktierungselement. Hierdurch wird eine besonders sichere Aufnahme der Kontaktierung bzw. des Kontaktierungselements an dem Kontaktierungsaufnahmeelement ermöglicht.

Alternativ oder zusätzlich kann es vorgesehen sein, dass das erste Kontaktierungsaufnahmeelement und/oder das zweite Kontaktierungsaufnahmeelement und/oder das dritte Kontaktierungsaufnahmeelement eine Flächenkontaktierung umfasst. Eine Flächenkontaktierung kann dabei als flächiges Element ausgebildet sein und beispielsweise mit einer dazu korrespondierenden Fläche bzw. einer Flächenaufnahme zusammenwirken, die zumindest abschnittsweise flächig mit der Flächenkontaktierung überlappt und so eine Kontaktierung herstellt. Alternativ oder zusätzlich kann die Flächenkontaktierung auch mit einer Federkontaktierung zusammenwirken und eines solche aufnehmen bzw. kontaktieren.

Insbesondere können sowohl an dem ersten und/oder zweiten und/oder dritten Kontaktierungsaufnahmeelement bzw. dem dazu korrespondierenden ersten und/oder zweiten und/oder dritten Kontaktierungselement Mittel oder Elemente vorgesehen sein, die sowohl eine Stift-Buchsen-Kontaktierung als auch eine Federkontaktierung als auch eine Flächenkontaktierung ermöglichen, unterstützen und/oder bereitstellen. Hierdurch ergibt sich eine besonders fehlerfreie Kontaktierung.

Gemäß einem weiteren Vorteil kann vorgesehen sein, dass das erste Kontaktierungsaufnahmeelement von dem zweiten Kontaktierungsaufnahmeelement und/oder von dem dritten Kontaktierungsaufnahmeelement verschieden ausgebildet ist. Insbesondere kann das erste Kontaktierungsaufnahmeelement eine oder mehrere von einer Stift-Buchsen-Kontaktierung, einer Federkontaktierung und einer Flächenkontaktierung umfassen und das zweite/dritte Kontaktierungsaufnahmeelement eine oder mehrere andere von einer Stift-Buchsen-Kontaktierung, einer Federkontaktierung und einer Flächenkontaktierung. Insbesondere kann das erste Kontaktierungsaufnahmeelement als Stift-Buchsen-Kontaktierung ausgebildet sein und das zweite bzw. dritte Kontaktierungsaufnahmeelement als Federkontaktierung und/oder als Flächenkontaktierung, die mit einer Federkontaktierung des zweiten bzw. dritten Kontaktierungselements zusammenwirkt. Hierdurch können die jeweils positiven Effekte der jeweiligen Kontaktierungsarten synergistisch kombiniert werden und so eine besonders sichere Kontaktierung hergestellt werden.

Optional kann es vorgesehen sein, dass der Hauptenergiefluss eine Wechselspannung von bis zu 1000 Volt und/oder eine Gleichspannung von bis zu 1500 Volt und/oder eine Wechselspannung im Bereich von 70 Volt bis 1000 Volt und/oder eine Gleichspannung im Bereich von 130 Volt bis 1500 Volt, und bevorzugt eine Wechselspannung von im Wesentlichen 400 Volt oder eine Gleichspannung im Bereich von 650 V bis 700 V, umfasst Alternativ oder zusätzlich kann vorgesehen sein, dass der Hilfsenergiefluss eine Wechselspannung von bis zu 50 Volt und/oder eine Gleichspannung bis zu 120 Volt und/oder eine Wechselspannung im Bereich von 0,01 Volt bis 50 Volt und/oder eine Gleichspannung im Bereich von 0,01 Volt bis 120 Volt, und bevorzugt eine Gleichspannung von im Wesentlichen 24 V oder 48 V umfasst.

Weiter kann der Datenfluss mindestens ein oder mehrere Signale zum Datenaustausch umfassen, vorzugsweise zur Bereitstellung eines Datenbusses und/oder eines Feldbusses. Mit anderen Worten kann es vorgesehen sein, dass der Datenfluss ausgebildet ist, Daten- und vorzugsweise Feldbussignale zu übertragen, vorzugsweise zur Kommunikation mit wenigstens einem der zu steuernden Geräte.

Ebenfalls Gegenstand der Erfindung ist eine Automatisierungsplattform, umfassend eine Verbindungsvorrichtung nach einer oder mehrerer der zuvor beschriebenen Ausführungsformen, sowie zumindest ein Funktionsmodul. Insbesondere kann die Automatisierungsplattform mehr als ein Funktionsmodul aufweisen, beispielsweise zwei, drei oder mehr, wovon zumindest ein Funktionsmodul über eine Verbindungsvorrichtung nach einer oder mehrerer der zuvor beschriebenen Ausführungsformen mit der Automatisierungsplattform verbunden und/oder verbindbar ist.

Optional kann es vorgesehen sein, dass die Automatisierungsplattform eine weitere Verbindungsvorrichtung nach einer oder mehrerer der zuvor beschriebenen Ausführungsformen umfasst, wobei jede der zumindest zwei Verbindungsvorrichtungen mit zumindest je einem Funktionsmodul verbindbar ist, wobei die Verbindungsvorrichtungen ausgebildet sind, um zumindest einen von dem Hauptenergiefluss, dem Hilfsenergiefluss und/oder dem Datenfluss an die Funktionsmodule bereitzustellen. Dabei kann insbesondere jedes der Funktionsmodule eine unterschiedliche Funktion für die Automatisierungsplattform bereitstellen. Insbesondere kann eine erste Verbindungsvorrichtung nach einer oder mehrerer der zuvor beschriebenen Ausführungsformen vorgesehen sein, die mit einem ersten Funktionsmodul verbindbar und/oder verbunden ist und eine zweite Verbindungsvorrichtung nach einer oder mehrerer der zuvor beschriebenen Ausführungsformen, die mit einem zweiten, insbesondere von dem ersten Funktionsmodul verschiedenen Funktionsmodul verbindbar und/oder verbunden ist. Das erste Funktionsmodul kann dabei eine erste Funktion innerhalb der Automatisierungsplattform bereitstellen und das zweite Funktionsmodul eine zweite, von der ersten Funktion verschiedene Funktion bereitstellen.

Gemäß einem weiteren Vorteil kann vorgesehen sein, dass die Verbindungsvorrichtungen derart zueinander angeordnet und ausgebildet sind, dass sie zumindest einen von dem Hauptenergiefluss, dem Hilfsenergiefluss und/oder dem Datenfluss seriell an die Funktionsmodule bereitstellen. Insbesondere sind auch die Funktionsmodule derart zueinander angeordnet und ausgebildet, dass sie zumindest einen von dem Hauptenergiefluss, dem Hilfsenergiefluss und/oder dem Datenfluss seriell an anderen die Funktionsmodule bereitstellen. Mit anderen Worten sind die ersten Kontaktierungsaufnahmeelemente und/oder die zweiten Kontaktierungsaufnahmeelemente bzw. der daran anliegende Hauptenergiefluss, Hilfsenergiefluss und/oder Datenfluss derart miteinander verschaltet, dass sie in Reihe, das bedeutet seriell miteinander verschaltet sind, sodass jeweils mindestens ein Hauptenergiefluss, ein Hilfsenergiefluss und/oder ein Datenfluss bereitgestellt wird, von dem bzw. mit dem die Kontaktierungsaufnahmeelemente verbunden sind und von dem die Kontaktierungsaufnahmeelemente gespeist werden. Die Kontaktierungsaufnahmeelemente sind dabei insbesondere derart verschaltet, dass sie den Hauptenergiefluss, den Hilfsenergiefluss und/oder den Datenfluss aufnehmen und weiterleiten können.

Vorteilhafterweise kann bei der Erfindung vorgesehen sein, dass die Automatisierungsplattform weiter ein Brückenelement umfasst, das mit einer der Verbindungsvorrichtungen verbunden ist und das ausgebildet ist, zumindest einen von dem Hauptenergiefluss, dem Hilfsenergiefluss und/oder dem Datenfluss zu empfangen und an ein eine weitere Verbindungsvorrichtung bereitzustellen. Ein solches Brückenelement, das auch als Leerelement oder als Blindelement bezeichnet werden kann, kann in einer oder mehreren Kontaktierungsaufnahmeelemente von einer oder mehreren Verbindungsvorrichtungen aufgenommen werden und eine Weiterleitungsfunktionalität bereitstellen, insbesondere dann, wenn kein Funktionsmodul in der jeweiligen Verbindungsvorrichtung aufgenommen ist. Insbesondere ist das Brückenelement ausgebildet, in einem von einer Verbindungsvorrichtung aufgenommenen Zustand einen oder mehrere von dem Hauptenergiefluss, dem Hilfsenergiefluss und/oder dem Datenfluss aufzunehmen und an eine weitere Verbindungsvorrichtung weiterzuleiten, insbesondere durchzuschleifen und/oder zu überbrücken, sodass einer oder mehrere von dem Hauptenergiefluss, dem Hilfsenergiefluss und/oder dem Datenfluss, insbesondere bei einer seriellen Verschaltung, nicht unterbrochen wird. Darüber hinaus kann das Brückenelement auch das erste und/oder zweite und/oder dritte Kontaktierungsaufnahmeelement vor äußeren Einflüssen, wie Staub oder Dreck schützen.

Es ist denkbar, dass die Verbindungsvorrichtung zusätzlich zum ersten und zweiten auch ein drittes Kontaktierungsaufnahmeelement umfasst, das in der ersten Ebene oder in der zweiten Ebene oder in einer dritten Ebene angeordnet ist. Das dritte Kontaktierungsaufnahmeelement kann dazu ausgebildet sein, eine dritte Kontaktierung mit einem zu dem dritten Kontaktierungsaufnahmeelement korrespondierenden dritten Kontaktierungselement des Funktionsmoduls bereitzustellen. Weiter kann das erste Kontaktierungsaufnahmeelement ausgebildet sein, einen Hauptenergiefluss über das kontaktierte erste Kontaktierungselement an das Funktionsmodul bereitzustellen. Das zweite Kontaktierungsaufnahmeelement kann ausgebildet ist, einen Hilfsenergiefluss über das kontaktierte zweite Kontaktierungselement an das Funktionsmodul bereitzustellen. Das dritte Kontaktierungsaufnahmeelement kann ausgebildet sein, einen Datenfluss über das kontaktierte dritte Kontaktierungselement an das Funktionsmodul bereitzustellen. Die dritte Ebene kann sich von der ersten und/oder zweiten Ebene unterscheiden und vorzugsweise beabstandet von und/oder parallel zu der ersten und/oder zweiten Ebene angeordnet sein. Damit kann auch eine nicht-ebene, bspw. stufige Gehäuseseite der Verbindungsvorrichtung zur Anordnung von wenigstens zwei der Kontaktierungsaufnahmeelemente bereitgestellt werden.

Weiter ist es denkbar, dass die erste Ebene sich dadurch von der zweiten Ebene unterscheidet, dass die erste Ebene parallel und/oder derart versetzt zur zweiten Ebene angeordnet ist, dass die Kontaktierungsaufnahmeelemente in der ersten und zweiten Ebene das Funktionsmodul über die Kontaktierungselemente an gegenüberliegenden Seiten des Funktionsmoduls, vorzugsweise an einer Ober- und einer Unterseite oder an zwei gegenüberliegenden Außenseiten, kontaktieren. Hierzu sind ein Teil der Kontaktierungsaufnahmeelemente z. B. an ein separates Kopplungs-/Adapter- /Deckelelement angebracht. Die Kontaktierung an den gegenüberliegenden Seiten kann dabei in einer gleichen Kontaktierungsebene und/oder aus unterschiedlichen und/oder gegenläufigen Kontaktierungsrichtungen erfolgen. Die Kontaktierungsebene kann dabei derart ausgerichtet sein, dass das Funktionsmodul in der Kontaktierungsebene liegt.

Weiter ist es denkbar, dass eines oder zwei der Kontaktierungsaufnahmeelemente an einem separaten Kopplungs-/Adapter-/Deckelelement angebracht ist/sind, welches dazu ausgeführt ist, erst nach der Kontaktierung des/der anderen (von dem einen oder den zwei der Kontaktierungsaufnahmeelemente sich unterscheidenden) Kontaktierungsaufnahmeelemente(s) am Funktionsmodul angebracht zu werden.

Ebenfalls optional unter Schutz gestellt ist ein System mit mindestens zwei (oder mindestens vier oder mindestens sechs) Automatisierungsplattformen, die jeweils optional als die voranstehend beschriebene erfindungsgemäße Automatisierungsplattform ausgebildet sein können. Dabei können die Automatisierungsplattformen jeweils als eine dezentrale Automatisierungsplattform ausgebildet sein und entsprechend dazu ausgebildet sein, jeweils Teilautomatisierungsfunktionen und insbesondere jeweils einen Teil einer Gesamtsteuerung für eine Automatisierung einer industriellen Anlage bereitzustellen. Dabei können die Automatisierungsplattformen dezentral im Feld der Anlage angeordnet sein, insbesondere, um gemeinsam eine Funktion eines zentralen Schaltschranks zu ersetzen. Weiter können die Automatisierungsplattformen über ein industrielles Kommunikationssystem und/oder einen Feldbus miteinander und/oder mit einer zentralen Steuerung verbunden sind.

Ebenfalls Gegenstand der Erfindung ist eine Anlage, vorzugsweise industrielle Anlage, mit mindestens zwei (oder mindestens vier oder mindestens sechs) Automatisierungsplattformen, die jeweils optional als die erfindungsgemäße Automatisierungsplattform ausgebildet sein können. Dabei können die Automatisierungsplattformen jeweils als eine dezentrale Automatisierungsplattform ausgebildet sein und entsprechend dazu ausgebildet sein, jeweils Teilautomatisierungsfunktionen und insbesondere jeweils einen Teil einer Gesamtsteuerung für die Automatisierung der industriellen Anlage bereitzustellen. Dabei können die Automatisierungsplattformen dezentral im Feld der Anlage angeordnet sein, insbesondere, um gemeinsam eine Funktion eines zentralen Schaltschranks zu ersetzen. Weiter können die Automatisierungsplattformen über ein industrielles Kommunikationssystem und/oder über einen Feldbus miteinander und/oder mit einer zentralen Steuerung verbunden sind. Die Automatisierungsplattformen können damit im Feld der Anlage verteilt und zusammen eingesetzt werden, um die Funktion des üblicherweise vorgesehenen zentralen Schaltschranks zu übernehmen. Dies kann den Vorteil haben, dass die Anlage flexibler gestaltet werden kann und insbesondere bei Erweiterungen oder Umbauten der Anlage eine einfache Anpassung der Automatisierungsfunktionen ermöglicht wird. Durch die dezentrale Anordnung der Automatisierungsplattformen kann zudem eine höhere Ausfallsicherheit erreicht werden, da bei einem Ausfall einer Plattform nicht die gesamte Automatisierung der Anlage betroffen ist. Es ist außerdem möglich, dass die Anlage durch die Verwendung der erfindungsgemäßen Automatisierungsplattformen kosteneffizienter gestaltet werden kann, da die Anschaffungskosten für einen zentralen Schaltschrank entfallen und die dezentrale Anordnung der Plattformen eine Reduktion der Verkabelungskosten ermöglicht.

Die jeweilige Automatisierungsplattform gemäß dem erfindungsgemäßen System und/oder der erfindungsgemäßen Anlage können optional umfassen:
jeweils eine Verbindungsvorrichtung sowie zumindest ein Funktionsmodul, wobei die jeweilige Verbindungsvorrichtung umfasst:
- ein erstes Kontaktierungsaufnahmeelement, das in einer ersten Ebene angeordnet ist und das ausgebildet ist, eine erste Kontaktierung mit einem zu dem ersten Kontaktierungsaufnahmeelement korrespondierenden ersten Kontaktierungselement des Funktionsmoduls bereitzustellen; und/oder
- ein zweites Kontaktierungsaufnahmeelement, das in einer zweiten Ebene, die sich von der ersten Ebene unterscheidet und vorzugsweise zu der ersten Ebene gewinkelt ist, angeordnet ist und das ausgebildet ist, eine zweite Kontaktierung mit einem zu dem zweiten Kontaktierungsaufnahmeelement korrespondierenden zweiten Kontaktierungselement des Funktionsmoduls bereitzustellen;
- wobei vorzugsweise das erste Kontaktierungsaufnahmeelement ausgebildet ist, zumindest einen von einem Hauptenergiefluss, einem Hilfsenergiefluss und einem Datenfluss über das erste Kontaktierungselement an das Funktionsmodul bereitzustellen und/oder wobei das zweite Kontaktierungsaufnahmeelement ausgebildet ist, zumindest einen weiteren von einem Hauptenergiefluss, einem Hilfsenergiefluss und einem Datenfluss über das zweite Kontaktierungselement an das Funktionsmodul bereitzustellen.

Die Automatisierungsplattformen können jeweils mit einer eigenen Stromversorgung und/oder einer Cloud-basierten Plattform zur Fernüberwachung und -steuerung und/oder einer integrierten Diagnosefunktion ausgestattet sein, um eine höhere Verfügbarkeit und Ausfallsicherheit, eine einfache Fehlerbehebung und eine automatische Fehlererkennung und -behebung zu gewährleisten. Dies kann den Vorteil haben, dass die Automatisierungsplattformen unabhängig von der Stromversorgung des Standorts betrieben werden können und somit für den Einsatz in verschiedenen Umgebungen geeignet sind. Es ist außerdem möglich, dass die Cloud-basierte Plattform zur Fernüberwachung und - steuerung es ermöglicht, dass die Automatisierungsplattformen von einem entfernten Standort aus überwacht und gesteuert werden können, was den Bedienkomfort erhöht. Die integrierte Diagnosefunktion kann dazu beitragen, dass mögliche Fehler schnell und einfach erkannt und behoben werden können, was die Wartung und Instandhaltung der Automatisierungsplattformen erleichtert und die Betriebskosten senkt.

Ein weiterer Vorteil der erfindungsgemäßen Automatisierungsplattform ist die Möglichkeit, einen digitalen Zwilling der industriellen Anlage zu erstellen und zu nutzen. Dabei handelt es sich insbesondere um eine virtuelle Darstellung der Anlage, die auf der Grundlage von Echtzeitdaten und Simulationen erstellt wird. Der digitale Zwilling kann dazu genutzt werden, um die Anlage zu optimieren, indem verschiedene Szenarien und Änderungen simuliert werden, bevor sie in der realen Anlage umgesetzt werden. Dies kann dazu beitragen, die Effizienz und Produktivität der Anlage zu steigern und gleichzeitig das Risiko von Fehlern und Ausfällen zu minimieren. Der digitale Zwilling kann auch dazu genutzt werden, um die Wartung und Instandhaltung der Anlage zu optimieren, indem mögliche Probleme frühzeitig erkannt und behoben werden können, bevor sie zu Ausfällen führen.

Die erfindungsgemäße Automatisierungsplattform bzw. die jeweilige Automatisierungsplattform einer erfindungsgemäße Anlage kann dazu ausgeführt sein, mehrere Funktionsmodule aufzunehmen, um diese über den Haupt- und/oder Hilfsenergiefluss mit Energie zu versorgen und/oder über den Datenfluss anzusteuern und/oder über den Datenfluss einen Datenaustausch für diese zu ermöglichen.

Die Funktionsmodule können unterschiedliche der Automatisierungsfunktionen, insbesondere in der Form von Teilautomatisierungsfunktionen, für die Automatisierung der industriellen Anlage bereitzustellen. Die Automatisierungsfunktionen können dabei wenigstens zwei der folgenden umfassen:
- Einen Motoransteuerung;
- Eine Ansteuerung und/oder Energieversorgung einer Motorsteuerung, welche vorzugsweise außerhalb der Automatisierungsplattform in Motornähe vorgesehen ist;
- Eine Ansteuerung und/oder Energieversorgung eines Aktuators, wie bspw. eines Motors, eines Ventils, eines Schrittmotors, eines Linearantriebs, eines Piezoaktors, eines Magnetaktors, eines Hydraulikzylinders, eines Pneumatikzylinders, eines Klappenantriebs, eines Greifarms, eines Roboterarms, eines Drehtisches, eines Förderbands, eines Kranarms, eines Schwenkarms, eines Bohrers, eines Schneiders, eines Schweißgeräts, eines Schneid- oder Gravierlasers, eines Vibrationsmotors, eines Lautsprechers, eines Aktors in der Medizintechnik, eines Aktors in der Automobilindustrie, eines Aktors in der Luft- und Raumfahrtindustrie, eines Aktors in der Robotik, eines Aktors in der Elektronik- oder Halbleiterindustrie, eines Aktors in der Lebensmittel- oder Verpackungsindustrie und/oder eines Aktors in der Textil- oder Papierindustrie;
- Ein Auslesen und/oder Ansteuern und/oder eine Energieversorgung eines Sensors, vorzugsweise eines Näherungssensors und/oder einer Lichtschranke.

Des Weiteren können die Funktionsmodule auch ein Sicherheitsmodul zur Überwachung und Absicherung von Prozessen und/oder einen Industrie-PC und/oder ein Feldbusmodul umfassen.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine perspektivische Ansicht einer Verbindungsvorrichtung gemäß Ausführungsbeispielen der Erfindung;
- Fig. 2: eine perspektivische Ansicht einer Verbindungsvorrichtung gemäß weiteren Ausführungsbeispielen der Erfindung;
- Fig. 3: eine perspektivische Ansicht einer Verbindungsvorrichtung gemäß weiteren Ausführungsbeispielen der Erfindung; und
- Fig. 4: perspektivische Ansicht einer Verbindungsvorrichtung gemäß weiteren Ausführungsbeispielen der Erfindung.
- Fig. 5: eine schematische Darstellung einer industriellen Anlage.

In den nachfolgenden Figuren werden für die gleichen technischen Merkmale auch von unterschiedlichen Ausführungsbeispielen die identischen Bezugszeichen verwendet.

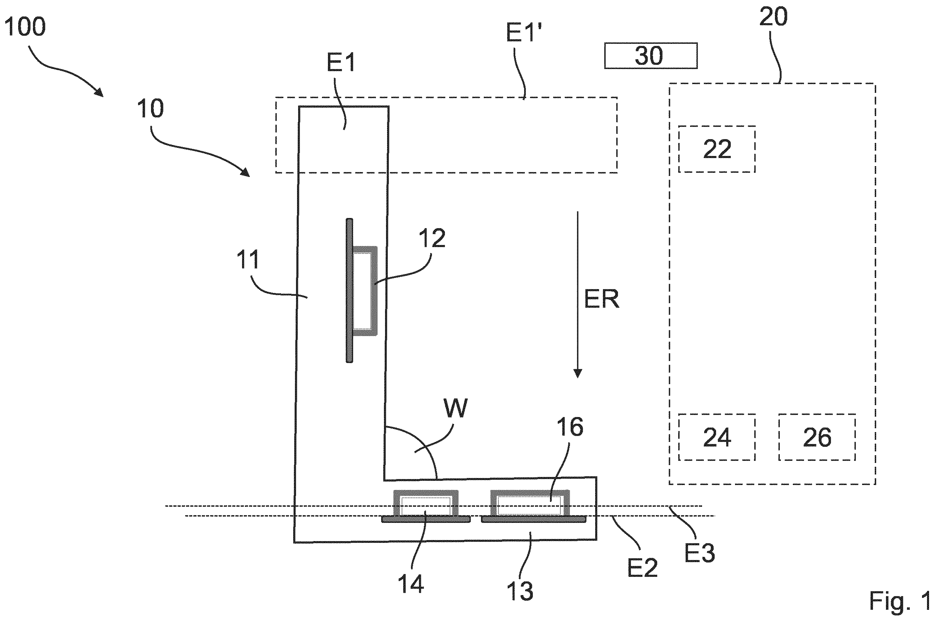

Fig. 1 veranschaulicht eine perspektivische Ansicht einer Verbindungsvorrichtung 10 gemäß Ausführungsbeispielen der Erfindung.

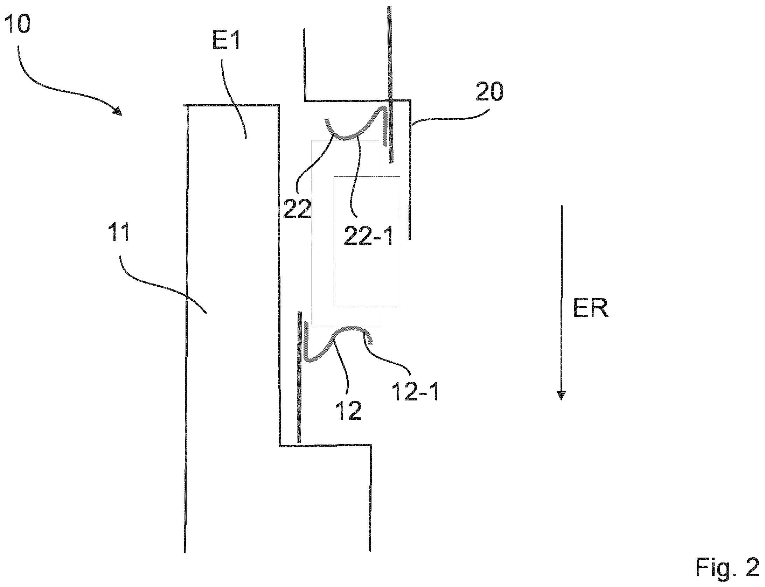

Die Verbindungsvorrichtung 10 dient zum Anschluss einer oder mehrerer Funktionsmodule an eine Automatisierungsplattform, welche hier nicht im Detail abgebildet ist. Das Funktionsmodul und dazugehörige Kontaktierungselemente bzw. deren Ausgestaltungen sind in dieser Fig. nicht im Detail gezeigt sondern werden im Zusammenhang mit den weiteren Fig. 2 bis 4 erläutert. Insbesondere können mehrere solcher hier in dieser Fig. 1 gezeigten Verbindungsvorrichtungen vorgesehen sein, die insbesondere seriell miteinander verschaltet sind. Die Automatisierungsplattform kann beispielsweise mehrere Verbindungsvorrichtungen und optional ein oder mehrere Funktionsmodule umfassen.

Dazu umfasst die Verbindungsvorrichtung 10 zunächst ein erstes Kontaktierungsaufnahmeelement 12, das in einer ersten Ebene E1 angeordnet ist und das ausgebildet ist, eine erste Kontaktierung mit einem zu dem ersten Kontaktierungsaufnahmeelement 12 korrespondierenden ersten Kontaktierungselement eines Funktionsmoduls bereitzustellen. Die Verbindungsvorrichtung 10 umfasst auch ein zweites Kontaktierungsaufnahmeelement 14, das in einer zweiten Ebene E2 angeordnet ist und das ausgebildet ist, eine zweite Kontaktierung mit einem zu dem zweiten Kontaktierungsaufnahmeelement 14 korrespondierenden zweiten Kontaktierungselement des Funktionsmoduls bereitzustellen. In dieser Fig. 1 ist zusätzlich noch ein optionales, drittes Kontaktierungsaufnahmeelement 16 gezeigt, das ebenfalls in der zweiten Ebene E2 angeordnet ist. Alternativ kann das dritte Kontaktierungsaufnahmeelement 16 in der ersten Ebene E1 oder in einer dritten Ebene E3 angeordnet sein.

Die erste Ebene E1 kann dabei zu der zweiten Ebene E2 gewinkelt ausgebildet sein. Insbesondere spannen die erste Ebene E1 und die zweite Ebene E2 einen Winkel W zwischen sich auf, der im Wesentlichen bei 90° liegt. Wie in dieser Fig. 1 insbesondere zu sehen, ist liegt das erste Kontaktierungsaufnahmeelement 12 in einem ersten Schenkel 11 und das zweite Kontaktierungsaufnahmeelement 14 und das dritte Kontaktierungsaufnahmeelement 16 in einem zweiten Schenkel 13 der Verbindungsvorrichtung 10, wobei die beiden Schenkel im Wesentlichen ebenfalls senkrecht zueinander angeordnet sind bzw. sich ein rechter Winkel W zwischen den beiden Schenkeln aufspannt. Mit anderen Worten sind die beiden Schenkel 11 und 13 in einer L-Form zueinander angeordnet bzw. ist die Verbindungsvorrichtung 10 im Wesentlichen L-förmig ausgebildet.

Das erste Kontaktierungsaufnahmeelement 12 ist dabei ausgebildet, einen von einem Hauptenergiefluss, einem Hilfsenergiefluss und einem Datenfluss über das erste Kontaktierungselement an das Funktionsmodul bereitzustellen. Das zweite Kontaktierungsaufnahmeelement 14 ist ausgebildet, einen weiteren von einem Hauptenergiefluss, einem Hilfsenergiefluss und einem Datenfluss über das zweite Kontaktierungselement an das Funktionsmodul bereitzustellen. Insbesondere ist das dritte Kontaktierungsaufnahmeelement 16 ausgebildet, einen noch weiteren von einem Hauptenergiefluss, einem Hilfsenergiefluss und einem Datenfluss über das erste Kontaktierungselement an das Funktionsmodul bereitzustellen. Beispielsweise stellt das erste Kontaktierungsaufnahmeelement 12 einen Hauptenergiefluss, das zweite Kontaktierungsaufnahmeelement 14 einen Hilfsenergiefluss und das dritte Kontaktierungsaufnahmeelement 16 einen Datenfluss über entsprechende Kontaktierungen an das Funktionsmodul bereit.

Der Hauptenergiefluss kann dabei eine Wechselspannung von bis zu 1000 Volt und/oder eine Gleichspannung von bis zu 1500 Volt und/oder eine Wechselspannung im Bereich von 70 Volt bis 1000 Volt und/oder eine Gleichspannung im Bereich von 130 Volt bis 1500 Volt, und bevorzugt eine Wechselspannung von im Wesentlichen 400 Volt oder eine Gleichspannung im Bereich von 650 V bis 700 V, umfassen. Ebenso kann der Hilfsenergiefluss eine Wechselspannung von bis zu 50 Volt und/oder eine Gleichspannung bis zu 120 Volt und/oder eine Wechselspannung im Bereich von 0,01 Volt bis 50 Volt und/oder eine Gleichspannung im Bereich von 0,01 Volt bis 120 Volt, und bevorzugt eine Gleichspannung von im Wesentlichen 24 V oder 48 V umfassen.

Die Kontaktierung zwischen dem jeweiligen Kontaktierungsaufnahmeelement und dem dazu korrespondierenden Kontaktierungselement kann dabei beispielsweise als Stift-Buchsen-Kontaktierung als Federkontaktierung, insbesondere als Federklammer, und/oder als Flächenkontaktierung ausgebildet sein und insbesondere auch Kombinationen daraus umfassen. Insbesondere ist die Kontaktierung zwischen dem ersten Kontaktierungsaufnahmeelement 12 und dem dazu korrespondierenden Kontaktierungselement des Funktionsmoduls anders ausgebildet als die Kontaktierung zwischen dem zweiten Kontaktierungsaufnahmeelement 14 und dem dazu korrespondierenden Kontaktierungselement des Funktionsmoduls bzw. sind die beiden Kontaktierungsarten verschieden.

Das hier in dieser Fig. 1 nicht gezeigte Funktionsmodul kann dabei insbesondere in der durch den Pfeil angezeigten Einführrichtung ER eingeführt werden, die im Wesentlichen parallel zu der ersten Ebene E1 und im Wesentlichen senkrecht zu der zweiten Ebene E2 liegt, um so das erste Kontaktierungsaufnahmeelement 12, das zweite Kontaktierungsaufnahmeelement 14 und optional das dritte Kontaktierungsaufnahmeelement 16 zu kontaktieren, wie dies nun im Zusammenhang mit den weiteren Figuren beschrieben werden wird.

Gemäß einer weiteren Ausführungsvariante kann gemäß Fig. 1 die erste Ebene E1' sich dadurch von der zweiten Ebene E2 unterscheidet, dass die erste Ebene E1' parallel aber derart versetzt zur zweiten Ebene E2 vorgesehen ist, dass die Kontaktierungsaufnahmeelemente 12, 14, 16 in der ersten und zweiten Ebene E1', E2 das (eingeführte) Funktionsmodul 20 von gegenüberliegenden Seiten kontaktieren. Hierzu kann bspw. das erste Kontaktierungsaufnahmeelement 12 in der ersten Ebene E1' vorgesehen sein, um einen Hauptenergiefluss über das erste Kontaktierungselement 22 an das Funktionsmodul 20 bereitzustellen. Dabei ist das Kontaktierungsaufnahmeelement 12 bspw. an einem Adapterstück 30 oder dergleichen in der ersten Ebene E1' befestigt. Die weiteren Kontaktierungsaufnahmeelemente 14, 16 können in der zweiten Ebene E2 vorgesehen sein. Das zweite Kontaktierungsaufnahmeelement 14 kann den Hilfsfluss über das zweite Kontaktierungselement 24 an das Funktionsmodul 20 bereitstellen und das dritte Kontaktierungsaufnahmeelement 16 kann den Datenfluss über das dritte Kontaktierungselement 26 an das Funktionsmodul 20 bereitstellen (vgl. Fig. 2).

Fig. 2 veranschaulicht eine perspektivische Ansicht einer Verbindungsvorrichtung 10 gemäß weiteren Ausführungsbeispielen der Erfindung.

Dabei ist in dieser Fig.2 beispielhaft gezeigt, dass das erste Kontaktierungsaufnahmeelement 12 als Federkontaktierung 12-1 ausgebildet ist. Ebenso ist das hier in dieser Fig. 2 gezeigte zu dem ersten Kontaktierungsaufnahmeelement 12 korrespondierende Kontaktierungselement 22 des Funktionsmoduls 20 als Federkontaktierung 22-1 ausgebildet. Die Federkontaktierung 12-1 des Kontaktierungsaufnahmeelements 12 und die dazu korrespondierende Federkontaktierung 22-1 des Kontaktierungselements 22 sind dabei derart zueinander angeordnet und ausgebildet dass sie entlang der Einführrichtung ER bzw. entgegengesetzt dazu federn.

Hierdurch wird auch eine Toleranz in der Einführrichtung ER bereitstellt, die etwaige Bewegungen des Funktionsmoduls 20 ausgleichen kann.

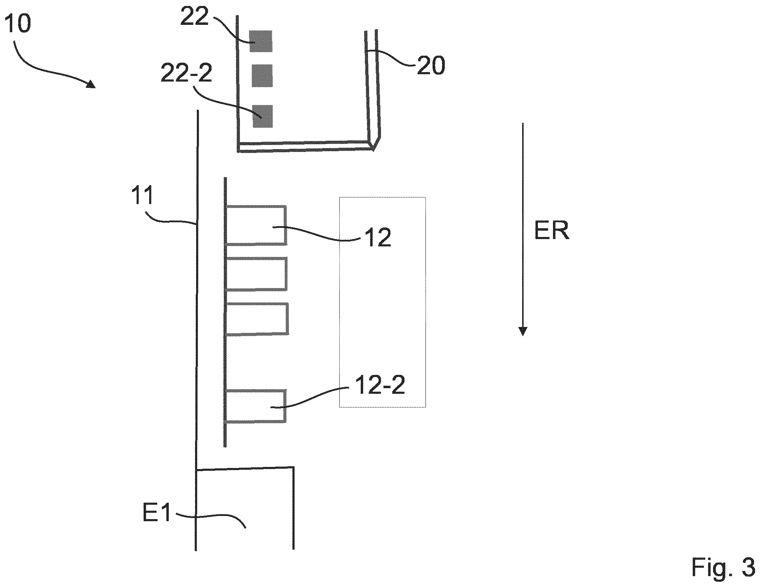

Fig. 3 veranschaulicht eine perspektivische Ansicht einer Verbindungsvorrichtung 10 gemäß weiteren Ausführungsbeispielen der Erfindung.

Dabei ist in dieser Fig. 3 beispielhaft gezeigt, dass das erste Kontaktierungsaufnahmeelement 12 als Flächenkontaktierung 12-2 ausgebildet ist. Ebenso ist das zu dem ersten Kontaktierungsaufnahmeelement 12 korrespondierende Kontaktierungselement 22 des Funktionsmoduls 20 als Flächenkontaktierung 22-2 ausgebildet. Insbesondere ist in diesem Ausführungsbeispiel das hier nicht gezeigte zweite Kontaktierungsaufnahmeelements als Stift-Buchsen-Kontaktierung ausgebildet, wodurch ein sicherer Halt gewährleistet wird und die Kontaktierung an dem ersten Kontaktierungsaufnahmeelement 14 lediglich durch einen flächigen Kontakt, insbesondere ohne weitere Haltemittel, ermöglicht werden kann.

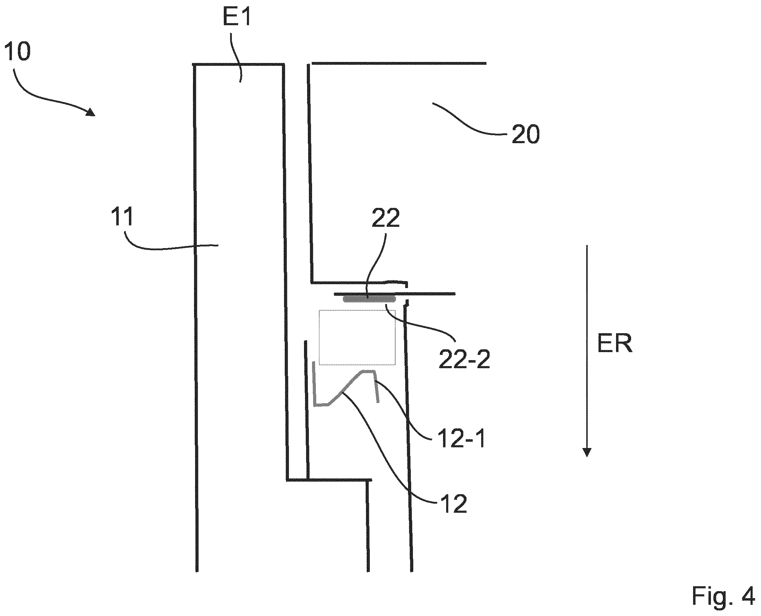

Fig. 4 veranschaulicht eine perspektivische Ansicht einer Verbindungsvorrichtung 10 gemäß weiteren Ausführungsbeispielen der Erfindung.

Dabei ist in dieser Fig.4 beispielhaft gezeigt, dass das erste Kontaktierungsaufnahmeelement 12 als Federkontaktierung 12-1 ausgebildet ist. Dabei ist jedoch abweichen das zu dem ersten Kontaktierungsaufnahmeelement 12 korrespondierende Kontaktierungselement 22 des Funktionsmoduls 20 als Flächenkontaktierung 22-2 ausgebildet. Die Federkontaktierung 12-1 des Kontaktierungsaufnahmeelements 12 und die dazu korrespondierende Flächenkontaktierung 22-2 des Kontaktierungselements 22 sind dabei derart zueinander angeordnet und ausgebildet dass sie entlang der Einführrichtung ER bzw. entgegengesetzt dazu federn. Hierdurch wird auch eine Toleranz in der Einführrichtung ER bereitstellt, die etwaige Bewegungen des Funktionsmoduls 20 ausgleichen kann.

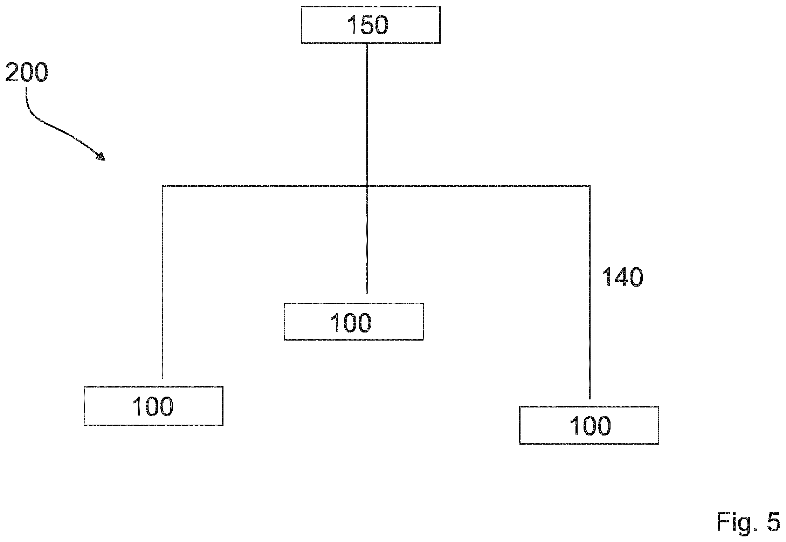

In Fig. 5 ist schematisch eine industrielle Anlage 200 mit mindestens zwei Automatisierungsplattformen 100 dargestellt. Dabei können die Automatisierungsplattformen 100 jeweils als eine dezentrale Automatisierungsplattform 100 ausgebildet sein, und entsprechend dazu ausgebildet sein, jeweils Teilautomatisierungsfunktionen und insbesondere jeweils einen Teil einer Gesamtsteuerung für die Automatisierung der industriellen Anlage 200 bereitzustellen. Hierzu können die Automatisierungsplattformen 100 dezentral im Feld der Anlage 200 angeordnet sein, insbesondere, um gemeinsam eine Funktion eines zentralen Schaltschranks zu ersetzen, wobei die Automatisierungsplattformen 100 über einen Feldbus 140 miteinander und/oder mit einer zentralen Steuerung 150 verbunden sind.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 10: Verbindungsvorrichtung
- 11: erster Schenkel
- 12: erstes Kontaktierungsaufnahmeelement
- 13: zweiter Schenkel
- 14: zweites Kontaktierungsaufnahmeelement
- 16: drittes Kontaktierungsaufnahmeelement

- 20: Funktionsmodul
- 22: erstes Kontaktierungselement
- 24: zweite Kontaktierungselement
- 26: drittes Kontaktierungselement

- 30: Deckel, Adapterstück

- 100: Automatisierungsplattform

- 12-1: Federkontaktierung
- 12-2: Flächenkontaktierung
- 22-1: Federkontaktierung
- 22-2: Flächenkontaktierung
- ER: Einführrichtung
- E1: erste Ebene
- E2: zweite Ebene
- W: Winkel

## Patentansprüche

1. Verbindungsvorrichtung (10) für eine Automatisierungsplattform, umfassend:
- ein erstes Kontaktierungsaufnahmeelement (12), das in einer ersten Ebene (E1) angeordnet ist und das ausgebildet ist, eine erste Kontaktierung mit einem zu dem ersten Kontaktierungsaufnahmeelement (12) korrespondierenden ersten Kontaktierungselement (22) eines Funktionsmoduls (20) bereitzustellen; und
- ein zweites Kontaktierungsaufnahmeelement (14), das in einer zweiten Ebene (E2), die sich von der ersten Ebene (E1) unterscheidet und vorzugsweise zu der ersten Ebene (E1) gewinkelt ist, angeordnet ist und das ausgebildet ist, eine zweite Kontaktierung mit einem zu dem zweiten Kontaktierungsaufnahmeelement (14) korrespondierenden zweiten Kontaktierungselement des Funktionsmoduls (20) bereitzustellen;
wobei das erste Kontaktierungsaufnahmeelement (12) ausgebildet ist, zumindest einen von einem Hauptenergiefluss, einem Hilfsenergiefluss und einem Datenfluss über das erste Kontaktierungselement (22) an das Funktionsmodul (20) bereitzustellen und wobei das zweite Kontaktierungsaufnahmeelement (14) ausgebildet ist, zumindest einen weiteren von einem Hauptenergiefluss, einem Hilfsenergiefluss und einem Datenfluss über das zweite Kontaktierungselement (24) an das Funktionsmodul (20) bereitzustellen.

2. Verbindungsvorrichtung (10) nach Anspruch 1,
**dadurch gekennzeichnet,**
**dass** das erste Kontaktierungsaufnahmeelement (12) und/oder das zweite Kontaktierungsaufnahmeelement (14) zur Ausbildung einer Steckverbindung ausgeführt ist, und insbesondere eine Stift-Buchsen-Kontaktierung umfasst.

3. Verbindungsvorrichtung (10) nach einem der vorhergehenden Ansprüche,
**dadurch gekennzeichnet,**
**dass** das erste Kontaktierungsaufnahmeelement (12) und/oder das zweite Kontaktierungsaufnahmeelement (14) eine Federkontaktierung (12-1) umfasst.

4. Verbindungsvorrichtung (10) nach Anspruch 3,
**dadurch gekennzeichnet,**
**dass** die erste Ebene (E1) und die zweite Ebene (E2) derart zueinander angeordnet sind, dass sie eine Einführung des Funktionsmoduls (20) in einer Einführrichtung (ER) ermöglichen, die im Wesentlichen senkrecht zu einer von der ersten Ebene (E1) und der zweiten Ebene (E2) ist und wobei die Federkontaktierung (12-1) derart angeordnet und ausgebildet ist, dass sie in der Einführrichtung (ER) federt, wobei vorzugsweise vorgesehen ist,
**dass** die Federkontaktierung (12-1) eine Toleranz in der Einführrichtung (ER) bereitstellt.

5. Verbindungsvorrichtung (10) nach einem der Ansprüche 3 oder 4,
**dadurch gekennzeichnet,**
**dass** die Federkontaktierung als Federklammer ausgebildet ist, wobei vorzugsweise vorgesehen ist,
**dass** die Federklammer angeordnet und ausgebildet ist, von einem Spreizelement des Funktionsmoduls (20) gespreizt zu werden.

6. Verbindungsvorrichtung (10) nach einem der vorhergehenden Ansprüche,
**dadurch gekennzeichnet,**
**dass** das erste Kontaktierungsaufnahmeelement (12) und/oder das zweite Kontaktierungsaufnahmeelement (14) eine Flächenkontaktierung (12-2) umfasst.

7. Verbindungsvorrichtung (10) nach einem der vorhergehenden Ansprüche,
**dadurch gekennzeichnet,**
**dass** der Hauptenergiefluss eine Wechselspannung von bis zu 1000 Volt und/oder eine Gleichspannung von bis zu 1500 Volt und/oder eine Wechselspannung im Bereich von 70 Volt bis 1000 Volt und/oder eine Gleichspannung im Bereich von 130 Volt bis 1500 Volt, und bevorzugt eine Wechselspannung von im Wesentlichen 400 Volt oder eine Gleichspannung im Bereich von 650 V bis 700 V, umfasst
und/oder
**dass** der Hilfsenergiefluss eine Wechselspannung von bis zu 50 Volt und/oder eine Gleichspannung bis zu 120 Volt und/oder eine Wechselspannung im Bereich von 0,01 Volt bis 50 Volt und/oder eine Gleichspannung im Bereich von 0,01 Volt bis 120 Volt, und bevorzugt eine Gleichspannung von im Wesentlichen 24 V oder 48 V umfasst, wobei vorzugsweise der Datenfluss mindestens ein oder mehrere Signale zum Datenaustausch umfasst, vorzugsweise zur Bereitstellung eines Datenbusses und/oder eines Feldbusses.

8. Verbindungsvorrichtung (10) nach einem der vorhergehenden Ansprüche,
**dadurch gekennzeichnet,**
**dass** das erste Kontaktierungsaufnahmeelement (12) von dem zweiten Kontaktierungsaufnahmeelement (14) verschieden ausgebildet ist.

9. Automatisierungsplattform (100), umfassend eine Verbindungsvorrichtung (10) nach einem der vorhergehenden Ansprüche sowie zumindest ein Funktionsmodul (20).

10. Automatisierungsplattform (100) nach Anspruch 9, umfassend eine weitere Verbindungsvorrichtung nach einem der Ansprüche 1 bis 8, wobei jede der Verbindungsvorrichtungen mit zumindest je einem Funktionsmodul verbindbar ist, wobei die Verbindungsvorrichtungen ausgebildet sind, um zumindest einen von dem Hauptenergiefluss, dem Hilfsenergiefluss und dem Datenfluss an die Funktionsmodule bereitzustellen, wobei insbesondere jedes der Funktionsmodule eine unterschiedliche Funktion für die Automatisierungsplattform bereitstellt.

11. Automatisierungsplattform (100) nach Anspruch 10,
**dadurch gekennzeichnet,**
**dass** die Verbindungsvorrichtungen derart zueinander angeordnet und ausgebildet sind, dass sie zumindest einen von dem Hauptenergiefluss, dem Hilfsenergiefluss und/oder dem Datenfluss seriell an die Funktionsmodule bereitstellen.

12. Automatisierungsplattform (100) nach einem der Ansprüche 9 bis 11,
weiter umfassend ein Brückenelement, das mit einer der Verbindungsvorrichtungen verbunden ist und das ausgebildet ist, zumindest einen von dem Hauptenergiefluss, dem Hilfsenergiefluss und dem Datenfluss zu empfangen und an ein eine weitere Verbindungsvorrichtung bereitzustellen.

13. Automatisierungsplattform (100) nach einem der Ansprüche 9 bis 12,
**dadurch gekennzeichnet,**
**dass** die Verbindungsvorrichtung (10) ferner umfasst:
- ein drittes Kontaktierungsaufnahmeelement (16), das in der ersten Ebene (E1,E1') oder in der zweiten Ebene (E2) oder in einer dritten Ebene (E3) angeordnet ist und das ausgebildet ist, eine dritte Kontaktierung mit einem zu dem dritten Kontaktierungsaufnahmeelement (16) korrespondierenden dritten Kontaktierungselement (26) des Funktionsmoduls (20) bereitzustellen, wobei
das erste Kontaktierungsaufnahmeelement (12) ausgebildet ist, einen Hauptenergiefluss über das kontaktierte erste Kontaktierungselement (22) an das Funktionsmodul (20) bereitzustellen, und dass das zweite Kontaktierungsaufnahmeelement (14) ausgebildet ist, einen Hilfsenergiefluss über das kontaktierte zweite Kontaktierungselement (24) an das Funktionsmodul (20) bereitzustellen, und dass das dritte Kontaktierungsaufnahmeelement (16) ausgebildet ist, einen Datenfluss über das kontaktierte dritte Kontaktierungselement (26) an das Funktionsmodul (20) bereitzustellen.

14. Automatisierungsplattform (100) nach Anspruch 13,
**dadurch gekennzeichnet,**
**dass** die erste Ebene (E1') sich dadurch von der zweiten Ebene (E2) unterscheidet, dass die erste Ebene (E1') parallel und/oder derart versetzt zur zweiten Ebene (E2) angeordnet ist, dass die Kontaktierungsaufnahmeelemente (12, 14, 16) in der ersten und zweiten Ebene (E1', E2) das Funktionsmodul (20) über die Kontaktierungselemente (22, 24, 26) an gegenüberliegenden Seiten des Funktionsmoduls (20), vorzugsweise an einer Ober- und einer Unterseite oder ein zwei gegenüberliegenden Außenseiten, kontaktieren, wobei hierzu eines oder zwei der Kontaktierungsaufnahmeelemente (12, 14, 16) an einem separaten Kopplungs-/Adapter-/Deckelelement (30) angebracht ist/sind, welches dazu ausgeführt ist, erst nach der Kontaktierung des/der anderen Kontaktierungsaufnahmeelemente(s) (12, 14, 16) am Funktionsmodul (20) angebracht zu werden.

15. Industrielle Anlage (200) mit mindestens zwei Automatisierungsplattformen (100), vorzugsweise jeweils nach einem der Ansprüche 9 bis 14,
jeweils umfassend eine Verbindungsvorrichtung (10) sowie zumindest ein Funktionsmodul (20), wobei die jeweilige Verbindungsvorrichtung (10) umfasst:
- ein erstes Kontaktierungsaufnahmeelement (12), das in einer ersten Ebene (E1) angeordnet ist und das ausgebildet ist, eine erste Kontaktierung mit einem zu dem ersten Kontaktierungsaufnahmeelement (12) korrespondierenden ersten Kontaktierungselement (22) des Funktionsmoduls (20) bereitzustellen; und
- ein zweites Kontaktierungsaufnahmeelement (14), das in einer zweiten Ebene (E2), die sich von der ersten Ebene (E1) unterscheidet und vorzugsweise zu der ersten Ebene (E1) gewinkelt ist, angeordnet ist und das ausgebildet ist, eine zweite Kontaktierung mit einem zu dem zweiten Kontaktierungsaufnahmeelement (14) korrespondierenden zweiten Kontaktierungselement des Funktionsmoduls (20) bereitzustellen;
- wobei das erste Kontaktierungsaufnahmeelement (12) ausgebildet ist, zumindest einen von einem Hauptenergiefluss, einem Hilfsenergiefluss und einem Datenfluss über das erste Kontaktierungselement (22) an das Funktionsmodul (20) bereitzustellen und wobei das zweite Kontaktierungsaufnahmeelement (14) ausgebildet ist, zumindest einen weiteren von einem Hauptenergiefluss, einem Hilfsenergiefluss und einem Datenfluss über das zweite Kontaktierungselement (24) an das Funktionsmodul (20) bereitzustellen,
**dadurch gekennzeichnet,**
**dass** die Automatisierungsplattformen (100) jeweils als eine dezentrale Automatisierungsplattform (100) ausgebildet sind, und entsprechend dazu ausgebildet sind, jeweils Teilautomatisierungsfunktionen und insbesondere jeweils einen Teil einer Gesamtsteuerung für die Automatisierung der industriellen Anlage (200) bereitzustellen, wobei die Automatisierungsplattformen (100) dezentral im Feld der Anlage (200) angeordnet sind, insbesondere, um gemeinsam eine Funktion eines zentralen Schaltschranks zu ersetzen, wobei die Automatisierungsplattformen (100) über einen Feldbus (140) miteinander und/oder mit einer zentralen Steuerung (150) verbunden sind.
